# EUROPEAN PATENT APPLICATION

(11) **EP 4 571 821 A1**
(43) Date of publication of application: **18.06.2025**
(21) Application number: 23852420.1
(22) Date of filing: 31.07.2023
(51) Int. Cl.: H01L 21/66, H01L 21/304

(54) **METHOD FOR SUPPRESSING VARIATION IN LIGHT EMISSION INTENSITY OF BACKGROUND IN PHOTOLUMINESCENCE MEASUREMENT, AND EVALUATION METHOD FOR SEMICONDUCTOR SUBSTRATE**

(30) Priority: 09.08.2022 JP 2022127387
(71) Applicant: Kwansei Gakuin Educational Foundation, Nishinomiya-shi, Hyogo 662-8501 (JP); Toyota Tsusho Corporation, Nagoya-shi Aichi 450-8575 (JP)
(72) Inventor: KANEKO, Tadaaki, Sanda-shi, Hyogo 669-1330 (JP); DOJIMA, Daichi, Sanda-shi, Hyogo 669-1330 (JP); TODA, Kohei, Sanda-shi, Hyogo 669-1330 (JP); MAKI, Mizuho, Sanda-shi, Hyogo 669-1330 (JP)
(74) Representative: Schön, Christoph
(86) International application number: PCT/JP2023/027947
(87) International publication number: WO 2024/034448

(57) **Abstract**

A problem to be solved by the present invention is to provide a novel technology capable of suppressing variation in background light emission intensity in photoluminescence measurement. The present invention is a method for suppressing variation in background light emission intensity in photoluminescence measurement, the method including a subsurface damaged layer removal step S10 of removing at least a part of a subsurface damaged layer 11 present in a semiconductor substrate 10, and a photoluminescence measurement step S30 of acquiring distribution information of crystal defects of the semiconductor substrate 10 by photoluminescence measurement.

## Description

### Technical Field

The present invention relates to a method for suppressing variation in background light emission intensity in photoluminescence measurement, and a method for evaluating a semiconductor substrate.

### Background Art

As next-generation semiconductor materials replacing silicon (Si), compound semiconductors such as silicon carbide (SiC), gallium nitride (GaN), gallium oxide (Ga₂O₃), and aluminum nitride (AlN) have attracted attention.

For example, SiC has a dielectric breakdown electric field one digit larger than that of Si, a band gap three times larger than that of Si, and a thermal conductivity about three times higher than that of Si. Therefore, SiC is expected to be applied to power devices, high frequency devices, high temperature operation devices and the like.

However, many crystal defects still exist in SiC substrates and SiC epitaxial substrates, and it is known that these crystal defects adversely affect characteristics of SiC devices.

Conventionally, as a method for acquiring distribution information of crystal defects, an etch pit method for preferentially etching crystal defect sites using a strong alkaline melt to form a pit shape, and dislocation density evaluation by topography using a radiation facility have been performed.

However, since the etch pit method is a destructive inspection for forming a pit shape on a substrate, there has been a problem that a SiC device cannot be manufactured using the inspected substrate. In the dislocation density evaluation by topography using a radiation facility, it is necessary to use a large facility such as a radiation facility, so that there has been a problem that it is difficult to easily evaluate.

In order to solve such a problem, Patent Literature 1 discloses that it is not necessary to perform a destructive inspection, and that photoluminescence measurement is adopted as a method for evaluating crystal defects without using a large facility such as a radiation facility.

### Citation List

### Patent Literature

Patent Literature 1: JP 2021-88469 A

### Summary of Invention

### Technical Problem

Photoluminescence measurement is a method for irradiating a semiconductor substrate to be measured with excitation light and measuring light emitted when excited electrons return to a ground state. In a captured image obtained by photoluminescence measurement, distribution information of crystal defects is obtained by contrast between light emission intensity of a portion in which crystal defects such as dislocations and stacking faults are observed and light emission intensity of a background in which these crystal defects are not observed.

The "background" in the present specification is a region serving as a background of a portion in which crystal defects such as dislocations and stacking faults are observed when distribution information of crystal defects of a semiconductor substrate is acquired by photoluminescence measurement, and in other words, a region in which these crystal defects are not observed.

As a result of intensive studies, the present inventors and the like have found that, in a case where a subsurface damaged layer and/or macro-step bunching (MSB) is present in a semiconductor substrate to be measured, a background light emission intensity varies, and an accurate captured image cannot be obtained.

A problem to be solved by the present invention is to provide a novel technology capable of suppressing variation in background light emission intensity in photoluminescence measurement.

### Solution to Problem

The present invention to solve the above-described problems is a method for suppressing variation in background light emission intensity in photoluminescence measurement, the method including a subsurface damaged layer removal step of removing at least a part of a subsurface damaged layer present in a semiconductor substrate, and a photoluminescence measurement step of acquiring distribution information of crystal defects of the semiconductor substrate by photoluminescence measurement.

The present invention to solve the above-described problems is a method for suppressing variation in background light emission intensity in photoluminescence measurement, the method including a macro-step bunching removal step of removing at least a part of a macro-step bunching present in a semiconductor substrate, and a photoluminescence measurement step of acquiring distribution information of crystal defects of the semiconductor substrate by photoluminescence measurement.

The present invention to solve the above-described problems is a method for suppressing variation in background light emission intensity in photoluminescence measurement, the method including a subsurface damaged layer removal step of removing at least a part of a subsurface damaged layer present in a semiconductor substrate, a macro-step bunching removal step of removing at least a part of a macro-step bunching present in the semiconductor substrate, and a photoluminescence measurement step of acquiring distribution information of crystal defects of the semiconductor substrate by photoluminescence measurement.

In a preferred mode of the present invention, the subsurface damaged layer removal step is a step of removing the subsurface damaged layer by a thermal etching method.

In a preferred mode of the present invention, the subsurface damaged layer removal step is a step of removing at least a part of the subsurface damaged layer by wet etching and/or chemical mechanical polishing.

In a preferred mode of the present invention, the macro-step bunching removal step is a step of removing the macro-step bunching by a thermal etching method.

In a preferred mode of the present invention, the macro-step bunching removal step is a step of heating the semiconductor substrate under a SiC-Si equilibrium vapor pressure environment.

In a preferred mode of the present invention, the macro-step bunching removal step is a step of forming a step having a height of one unit cell or less on a surface of the semiconductor substrate.

In a preferred mode of the present invention, the semiconductor substrate is a compound semiconductor.

The present invention also relates to a method for evaluating a semiconductor substrate. That is, the present invention to solve the above-described problems is a method for evaluating a semiconductor substrate, the method including performing photoluminescence measurement on a semiconductor substrate from which at least a part of a subsurface damaged layer is removed.

The present invention to solve the above-described problems is a method for evaluating a semiconductor substrate, the method including performing photoluminescence measurement on a semiconductor substrate from which at least a part of a macro-step bunching is removed.

The present invention to solve the above-described problems is a method for evaluating a semiconductor substrate, the method including performing photoluminescence measurement on a semiconductor substrate from which a subsurface damaged layer and a macro-step bunching are removed.

In a preferred mode of the present invention, the semiconductor substrate includes a step having a height of one unit cell or less.

In a preferred mode of the present invention, the semiconductor substrate is a compound semiconductor.

### Advantageous Effects of Invention

According to the disclosed technology, it is possible to provide a novel technology capable of suppressing variation in background light emission intensity in photoluminescence measurement.

Other problems, features, and advantages will be apparent by reading the description of embodiments described below when taken in conjunction with the drawings and claims.

### Brief Description of Drawings

Fig. 1 is an explanatory view for explaining a subsurface damaged layer removal step and a macro-step bunching removal step according to the present invention.
Fig. 2 is an explanatory view for explaining a subsurface damaged layer removal step and a macro-step bunching removal step according to the present invention.
Fig. 3 is an explanatory view for explaining steps of Example 1 and Example 2.
Fig. 4 is an explanatory view for explaining a subsurface damaged layer removal step and a macro-step bunching removal step in Example 1.
Fig. 5 is an explanatory view for explaining a macro-step bunching formation step in Example 2.
Fig. 6 illustrates a captured image and an intensity profile obtained at a photoluminescence measurement step of a comparative example.
Fig. 7 illustrates a captured image and an intensity profile obtained at a photoluminescence measurement step of Example 1.
Fig. 8 illustrates a captured image and an intensity profile obtained at a photoluminescence measurement step of Example 2.

### Description of Embodiments

Hereinafter, preferred embodiments regarding a method for suppressing variation in background light emission intensity in photoluminescence measurement, and a method for evaluating a semiconductor substrate according to the present invention will be described in detail with reference to the accompanying drawings. The technical scope of the present invention is not limited to the embodiments illustrated in the accompanying drawings, and can be appropriately changed within the scope recited in claims. In the present specification and the drawings, in the notation of a Miller index, **"-"** means a bar corresponding to an index immediately after the same, and **"-"** is added before the index to express a negative index. Note that, in the following description of the embodiments and the accompanying drawings, the same reference sign is given to similar configurations, and redundant description is omitted.

A method for suppressing variation in background light emission intensity in photoluminescence measurement according to the present invention may include a subsurface damaged layer removal step S10 of removing at least a part of a subsurface damaged layer 11 present in a semiconductor substrate 10, a macro-step bunching removal step S20 of removing at least a part of a macro-step bunching MSB present in the semiconductor substrate 10, and a photoluminescence measurement step S30 of acquiring distribution information of crystal defects of the semiconductor substrate 10 by photoluminescence measurement.

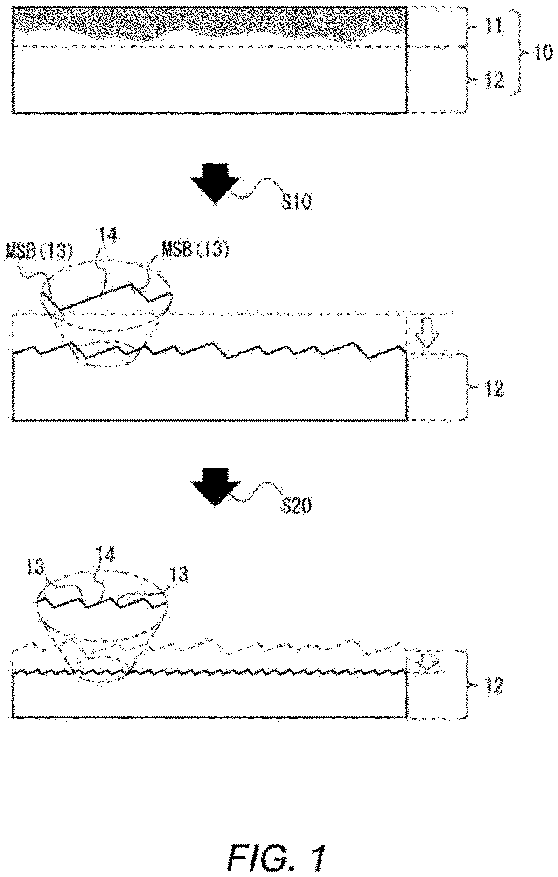

Fig. 1 illustrates an embodiment in which the macro-step bunching removal step S20 is performed after the subsurface damaged layer removal step S10 is performed. In this embodiment, the subsurface damaged layer removal step S10 and the macro-step bunching removal step S20 can be grasped as different steps. For example, it is possible that only the macro-step bunching removal step S20 is performed on the semiconductor substrate 10 from which the subsurface damaged layer 11 has already been removed.

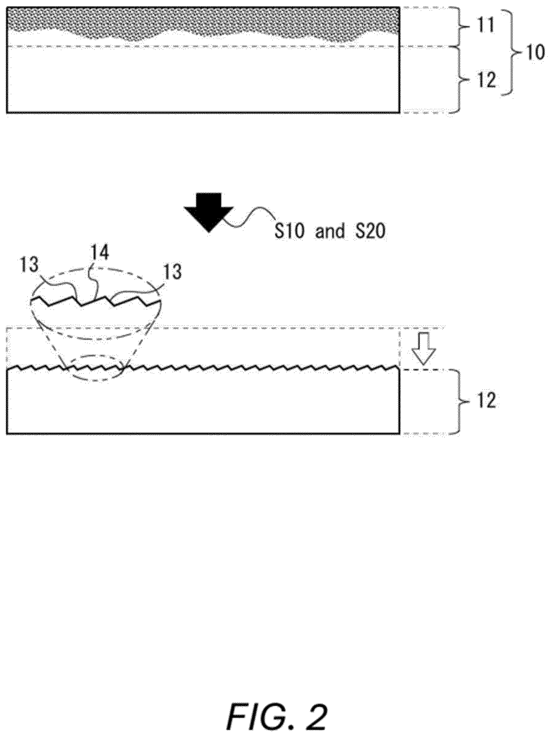

Fig. 2 illustrates an embodiment in which the subsurface damaged layer removal step S10 and the macro-step bunching removal step S20 are simultaneously performed. In this embodiment, the subsurface damaged layer 11 and the macro-step bunching MSB can be reduced or removed at one step.

In the present invention, by performing the photoluminescence measurement on the semiconductor substrate 10 from which at least a part of the subsurface damaged layer 11 is removed, it is possible to suppress variation in background light emission intensity in the photoluminescence measurement and to obtain a more accurate captured image. Note that, the variation in background light emission intensity is expected to increase as an introduction depth of the subsurface damaged layer 11 increases. Therefore, even if the subsurface damaged layer 11 is not completely removed, the variation in background light emission intensity can be suppressed by removing at least a part of the subsurface damaged layer 11.

In other words, the present invention is a method for evaluating a semiconductor substrate including a photoluminescence measurement step of performing photoluminescence measurement on the semiconductor substrate 10 from which at least a part of the subsurface damaged layer 11 is removed.

Note that, the "subsurface damaged layer" in the present specification refers to a layer introduced by performing machining on a surface of the semiconductor substrate 10. Note that, whether or not the "subsurface damaged layer" is reduced or removed can be confirmed by performing epitaxial growth on the semiconductor substrate 10 from which the subsurface damaged layer 11 is removed and observing and evaluating stacking faults formed during growth of an epitaxial layer. On the surface from which the subsurface damaged layer 11 is reduced or removed, occurrence of stacking faults formed during the growth of the epitaxial layer is suppressed.

In the present invention, by performing the photoluminescence measurement on the semiconductor substrate 10 from which at least a part of the macro-step bunching MSB is removed, it is possible to suppress variation in background light emission intensity in the photoluminescence measurement and to obtain a more accurate captured image. Note that, the variation in background light emission intensity is expected to increase as density of the macro-step bunching MSB increases. Therefore, even if the macro-step bunching MSB is not completely removed, the variation in background light emission intensity can be suppressed by removing at least a part of the macro-step bunching MSB.

In other words, the present invention is a method for evaluating a semiconductor substrate including a photoluminescence measurement step of performing photoluminescence measurement on the semiconductor substrate 10 from which at least a part of the macro-step bunching MSB is removed.

Note that the "macro-step bunching" in the present specification refers to a bunching having a height exceeding one unit cell in a step-terrace structure formed on the surface of the semiconductor substrate 10. For example, on a surface of SiC, a staircase structure is formed in which a step 13, which is a step portion of a monomolecular layer or more, and a terrace 14, which is a flat portion in which a {0001} plane is exposed, are alternately arranged. In the step 13 on the surface of SiC, the monomolecular layer (0.25 nm) has a minimum height (minimum unit), and a plurality of monomolecular layers bunches (bundles) to form the step 13 having various heights. Among the bunched steps 13, one having a height exceeding one unit cell of each polytype is referred to as the macro-step bunching MSB. That is, the macro-step bunching MSB is the step 13 obtained by bunching more than four molecular layers (five molecular layers or more) in a case of 4H-SiC, and is the step 13 obtained by bunching more than six molecular layers (seven molecular layers or more) in a case of 6H-SiC.

The present invention is a method for evaluating a semiconductor substrate including a photoluminescence measurement step of performing photoluminescence measurement on the semiconductor substrate 10 from which the subsurface damaged layer 11 and the macro-step bunching MSB are removed.

As a material of the semiconductor substrate 10, any commonly used material can be adopted. The material of the semiconductor substrate 10 includes, for example, a known group IV material such as silicon (Si), germanium (Ge), and diamond (C). The material of the semiconductor substrate 10 includes, for example, a known group IV-IV compound semiconductor material such as silicon carbide (SiC). The material of the semiconductor substrate 10 includes a known group II-VI compound semiconductor material such as zinc oxide (ZnO), zinc sulfide (ZnS), zinc selenide (ZnSe), cadmium sulfide (CdS), and cadmium telluride (CdTe). The material of the semiconductor substrate 10 includes, for example, a known group III-V compound semiconductor material such as boron nitride (BN), gallium arsenide (GaAs), gallium nitride (GaN), aluminum nitride (AlN), indium nitride (InN), gallium phosphide (GaP), indium phosphide (InP), and indium antimonide (InSb). The material of the semiconductor substrate 10 includes, for example, a known oxide semiconductor material such as aluminum oxide (Al₂O₃) and gallium oxide (Ga₂O₃). Note that, the semiconductor substrate 10 may have a configuration in which known additive atoms used according to the material thereof are appropriately added.

Note that, as a preferable material of the semiconductor substrate 10 used in the present invention, compound semiconductors such as silicon carbide (SiC), gallium nitride (GaN), gallium oxide (Ga₂O₃), and aluminum nitride (AlN) described above can be exemplified. Among them, SiC is a hard-brittle material and is classified as a material of which processing is extremely difficult. Therefore, it is not easy to reduce or remove the subsurface damaged layer 11 and the macro-step bunching MSB, and the semiconductor substrate 10 in which the subsurface damaged layer 11 and the macro-step bunching MSB remain is on the market, which causes variation in background light emission intensity in the photoluminescence measurement.

The subsurface damaged layer removal step S10 according to the present invention is a step of removing at least a part of the subsurface damaged layer 11 introduced by a step accompanied by machining such as slicing, rough grinding, finish grinding, and chemical mechanical polishing. More preferably, this is a step of removing the subsurface damaged layer 11 of the semiconductor substrate 10 to expose a bulk layer 12.

An existing method capable of removing at least a part of the subsurface damaged layer 11 can be adopted as the subsurface damaged layer removal step S10. For example, a thermal etching method, wet etching, chemical polishing by CMP (so-called chemical mechanical polishing), and other gas etching methods can be exemplified. As the thermal etching method, for example, H₂ etching, Si-vapor pressure etching, a sublimation etching method and the like can be adopted. More preferably, the sublimation etching method described in examples is preferably adopted.

Note that, chemical mechanical polishing involves machining, and thus the subsurface damaged layer 11 can be introduced at a step of chemical mechanical polishing; however, since this is slighter than the subsurface damaged layer 11 introduced at a preceding step such as slicing, rough grinding, and finish grinding, the chemical mechanical polishing can be adopted as a method capable of removing at least a part of the subsurface damaged layer 11.

By performing the subsurface damaged layer removal step S10, the subsurface damaged layer 11 introduced near the surface of the semiconductor substrate 10 can be reduced or removed, and the variation in background light emission intensity in the photoluminescence measurement can be suppressed.

The macro-step bunching removal step S20 according to the present invention is a step of removing at least a part of the macro-step bunching MSB present on the surface of the semiconductor substrate 10. More preferably, the step is a step of removing the macro-step bunching MSB of the semiconductor substrate 10 and forming the step 13 having a height of one unit cell or less on the surface.

An existing method capable of removing at least a part of the macro-step bunching MSB can be adopted as the macro-step bunching removal step S20. For example, a thermal etching method or an epitaxial growth method can be exemplified. As the thermal etching method, for example, H₂ etching, Si-vapor pressure etching, a sublimation etching method and the like can be adopted. As the epitaxial growth method, a CVD method or a sublimation method such as a proximity sublimation method can be adopted. More preferably, the sublimation etching method described in examples to be described later is adopted.

By performing the macro-step bunching removal step S20, the macro-step bunching MSB formed on the surface of the semiconductor substrate 10 can be reduced or removed, and the variation in background light emission intensity in the photoluminescence measurement can be suppressed.

The macro-step bunching removal step S20 may be performed simultaneously with the subsurface damaged layer removal step S10 (refer to Fig. 2).

The photoluminescence measurement step S30 according to the present invention can adopt existing photoluminescence measurement, and is a step of performing the photoluminescence measurement using a device conventionally used for measuring crystal defects of the semiconductor substrate 10.

In the photoluminescence measurement, excitation light having energy larger than a band gap of the semiconductor substrate 10 is emitted. As a result, holes and electrons present in the semiconductor substrate 10 are excited, and emit light when recombination occurs. Since characteristics of the emitted light vary depending on types of crystal defects, the presence or absence of various crystal defects can be discriminated by measuring the emitted light.

Note that, PL mapping for measuring an in-plane distribution of photoluminescence intensity by twodimensionally scanning the semiconductor substrate 10 with excitation light may be adopted, or PL imaging for simultaneously exciting a certain region of the semiconductor substrate 10 by irradiating a wide range with excitation light and measuring the in-plane distribution of photoluminescence intensity by a CCD camera or the like may be adopted.

### Examples

Hereinafter, the present invention is described more specifically on the basis of Example 1, Example 2, and a comparative example. Note that, the present invention is not limited to the following contents.

In Example 1, Example 2, and the comparative example, a 6-inch wafer of single crystal n-type 4H-SiC after chemical mechanical polishing was used as a semiconductor substrate 10. The semiconductor substrate 10 has a principal surface inclined at an off angle of 4° in a <11-20> direction with respect to a (0001) plane.

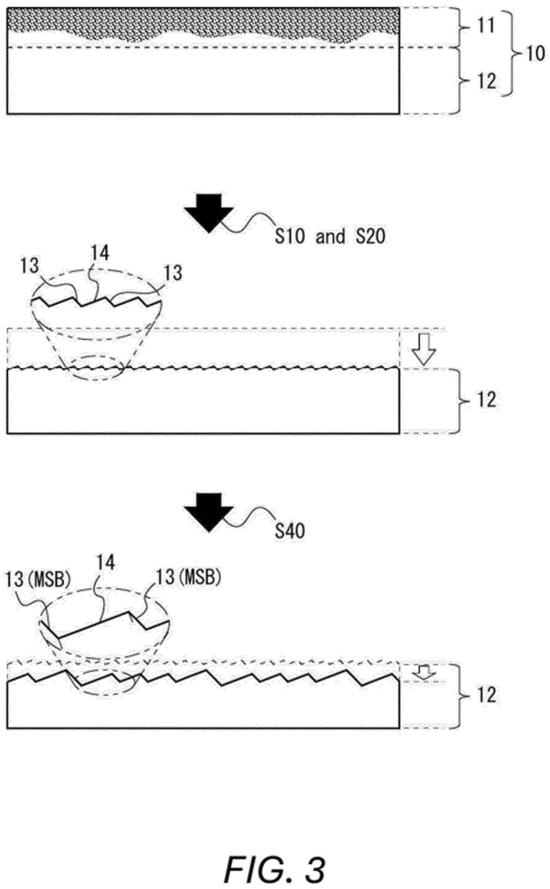

Fig. 3 is an explanatory view illustrating each step of the examples and comparative example of the present invention.

First, a photoluminescence measurement step S30 was performed on the semiconductor substrate 10 (comparative example).

Second, a subsurface damaged layer removal step S10 and a macro-step bunching removal step S20 were performed on the semiconductor substrate 10 subjected to photoluminescence measurement as the comparative example, and the photoluminescence measurement step S30 was performed under the condition similar to that in the comparative example (Example 1).

Finally, the semiconductor substrate 10 subjected to photoluminescence measurement as Example 1 was subjected to a macro-step bunching formation step S40 for forming a macro-step bunching MSB, and the photoluminescence measurement step S30 was performed under the condition similar to that in the comparative example and Example 1 (Example 2).

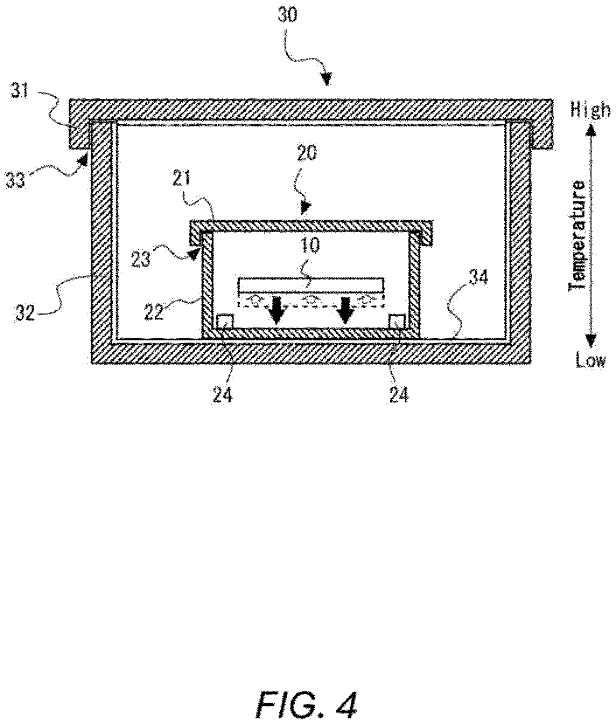

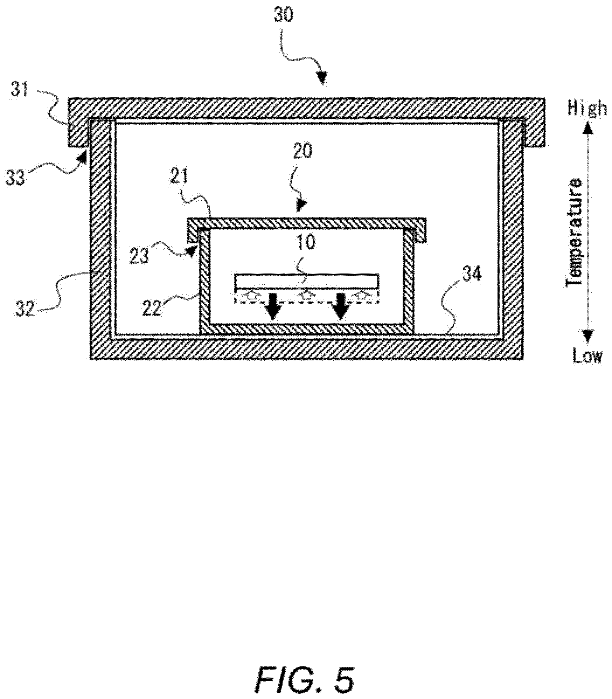

A device used at the subsurface damaged layer removal step S10, the macro-step bunching removal step S20, and the macro-step bunching formation step S40 is, for example, a device disclosed in WO 2021/025085, and a device including a main container 20, a refractory material container 30, and a heating furnace (not illustrated) that houses the main container 20 and the refractory material container 30 and can heat to form a temperature gradient was used. (Refer to Figs. 4 and 5)

It is only required that the main container 20 be configured to be able to house the semiconductor substrate 10 and generate vapor pressures of gas phase species containing a Si element and gas phase species containing a C element in an internal space during heat treatment. For example, the main container 20 is formed of a material containing SiC, and is preferably formed of a material containing single-crystal Sic and/or polycrystalline SiC. The main container 20 preferably has a mode in which SiC is exposed on at least a part of a container inner surface.

In the embodiment illustrated in Figs. 4 and 5, an entire main container 20 is formed of single-crystal Sic and/or polycrystalline SiC. By heating the main container 20 formed of such material, the vapor pressures of the gas phase species containing the Si element and the gas phase species containing the C element can be generated in the main container 20.

That is, it is desirable that an environment in the heat-treated main container 20 be a vapor pressure environment of a mixed system of the gas phase species containing the Si element and the gas phase species containing the C element. As the gas phase species containing the Si element, Si, Si₂, Si₃, Si₂C, SiC₂, and SiC can be exemplified. As the gas phase species containing the C element, Si₂C, SiC₂, SiC, and C can be exemplified. That is, a SiC-based gas is present in the main container 20.

Note that, when it is configured to generate the vapor pressures of the gas phase species containing the Si element and the gas phase species containing the C element in the internal space at the time of heat treatment of the main container 20, the structure may be adopted. For example, there may be a configuration in which the single-crystal SiC and polycrystalline SiC are exposed on a part of the inner surface, a configuration in which the single-crystal SiC and polycrystalline SiC are separately arranged in the main container 20 and the like.

As illustrated in Figs. 4 and 5, the main container 20 is a fitting container including an upper container 21 and a lower container 22 that can be fitted to each other. A minute gap 33 is formed in a fitting portion between the upper container 21 and the lower container 22, and it is configured that the main container 20 can be exhausted (evacuated) from the gap 23. That is, it is configured that the inside of the main container 20 is a semi-closed space when being exhausted.

The "semi-closed space" in the present specification refers to a space in the container that can be evacuated and can confine at least a part of vapor generated in the container. This semi-closed space can be formed in the container.

Depending on whether or not a Si-vapor supply source 24 is arranged in the main container 20, a mode in which the semiconductor substrate 10 is heated under a SiC-Si equilibrium vapor pressure environment and a mode in which this is heated under a SiC-C equilibrium vapor pressure environment can be selected.

The SiC-Si equilibrium vapor pressure environment is a vapor pressure environment when SiC (solid) and Si (liquid phase) are in a phase equilibrium state via a gas phase, and by performing etching or growth in this environment, the macro-step bunching MSB on the surface of the semiconductor substrate 10 can be removed.

The SiC-Si equilibrium vapor pressure environment can be formed by arranging the semiconductor substrate 10 in the quasi-closed space in which an atomic number ratio Si/C exceeds 1 and heating the semiconductor substrate. For example, in a case where the semiconductor substrate 10 satisfying a stoichiometric ratio 1:1 and the Si-vapor supply source 24 (Si pellet or the like) are arranged in a container made of SiC (main container 20) satisfying the stoichiometric ratio 1:1, the atomic number ratio Si/C in the quasi-closed space exceeds 1 (refer to Fig. 4).

The SiC-C equilibrium vapor pressure environment is a vapor pressure environment when SiC (solid) and C (solid) are in a phase equilibrium state via a gas phase, and by performing etching or growth in this environment, the macro-step bunching MSB can be formed on the surface of the semiconductor substrate 10.

The SiC-C equilibrium vapor pressure environment can be formed by arranging the semiconductor substrate 10 in the quasi-closed space in which an atomic number ratio Si/C does not exceed 1 and heating the semiconductor substrate. For example, in a case where the semiconductor substrate 10 satisfying the stoichiometric ratio 1:1 is arranged in a container made of SiC (main container 20) satisfying the stoichiometric ratio 1:1, the atomic number ratio Si/C in the main container 20 is 1 (refer to Fig. 5). A C-vapor supply source (C pellet or the like) may be arranged to set the atomic number ratio Si/C to 1 or less.

By heating the main container 20 with a temperature gradient by the heating furnace, it is possible to transport Si-atoms and C-atoms on the semiconductor substrate 10 side to the main container 20 side by using a temperature difference provided between the semiconductor substrate 10 and the main container 20 as a driving force, and to etch the semiconductor substrate 10. That is, temperature of at least a part (for example, a bottom surface of the lower container 22) of the main container 20 becomes lower than that of the semiconductor substrate 10 due to the temperature gradient formed by the heating furnace, so that the driving force for transporting the Si-atoms and C-atoms on the semiconductor substrate 10 side to the main container 20 side is generated.

More specifically, it is heated in such a manner that, when temperature of the surface to be etched of the semiconductor substrate 10 is compared with temperature of the bottom surface of the lower container 22 facing this surface, the temperature on the semiconductor substrate 10 side is high and the temperature on the lower container 22 side is low. In this manner, by forming a space provided with a temperature difference between the semiconductor substrate 10 and the lower container 22 in the main container 20, the Si-atoms and C-atoms on the semiconductor substrate 10 side can be transported to the lower container 22 using the temperature difference as the driving force. Note that, although not illustrated, a substrate holder for holding the semiconductor substrate 10 may be provided.

Epitaxial growth can also be performed on the surface of the semiconductor substrate 10 by reversing the temperature gradient. For example, as the macro-step bunching removal step S20, the epitaxial growth may be performed under the SiC-Si equilibrium vapor pressure environment to remove the macro-step bunching MSB on the surface of the semiconductor substrate 10. As the macro-step bunching formation step S40, the epitaxial growth may be performed under the SiC-C equilibrium vapor pressure environment to form the macro-step bunching MSB on the surface of the semiconductor substrate 10.

The refractory material container 30 includes a refractory material. For example, C as a general-purpose heat-resistant member, W, Re, Os, Ta, and Mo as refractory metals, Ta₉C₈, HfC, TaC, NbC, ZrC, Ta₂C, TiC, WC, and MoC as carbides, HfN, TaN, BN, Ta₂N, ZrN, and TiN as nitrides, HfB₂, TaB₂, ZrB₂, NB₂, and TiB₂ as borides, polycrystalline SiC and the like can be exemplified.

Similarly to the main container 20, the refractory material container 30 is a fitting container including an upper container 31 and a lower container 32 that can be fitted to each other, and is configured to be able to house the main container 20. A minute gap 33 is formed in a fitting portion between the upper container 31 and the lower container 32, and it is configured that the refractory material container 30 can be exhausted (evacuated) from the gap 33. That is, it is configured that the inside of the refractory material container 30 is a semi-closed space when being exhausted.

The refractory material container 30 includes a Si-vapor supply source 34 capable of supplying vapor pressures of gas phase species containing the Si element into the refractory material container 30. It is only required that the Si-vapor supply source 34 is configured to generate Si-vapor in the refractory material container 30 at the time of heat treatment, and solid Si (Si pellet such as a single-crystal Si piece or Si powder) and a Si compound can be exemplified. For example, a layer obtained by silicidation of the refractory material may be provided inside the above-described refractory material container 30.

In addition, any configuration can be adopted as long as the vapor pressures of the gas phase species containing the Si element are formed in the refractory material container 30 at the time of heat treatment.

### (Comparative Example)

A captured image of a comparative example was acquired by PL imaging using a commercially available photoluminescence measurement device for 4H-SiC after chemical mechanical polishing in which a subsurface damaged layer 11 is considered to remain (photoluminescence measurement step S30). In the photoluminescence measurement, a high-pass filter having a wavelength of excitation light of 313 nm and a light receiving filter of 750 nm was used.

### (Example 1)

The semiconductor substrate 10 subjected to the photoluminescence measurement step S30 in the comparative example was etched at 1800 degrees for two hours under a SiC-Si equilibrium vapor pressure environment to prepare a semiconductor substrate 10 from which a subsurface damaged layer 11 is removed and a macro-step bunching MSB is not present on a surface (refer to subsurface damaged layer removal step S10 and macro-step bunching removal step S20, and Figs. 3 and 4). Thereafter, photoluminescence measurement was performed under a condition similar to that in the comparative example to acquire a captured image of Example 1 (photoluminescence measurement step S30). Note that, the presence or absence of the macro-step bunching MSB was confirmed by SEM and AFM. A step 13 having a height of 1.0 nm or less was formed on the surface of the semiconductor substrate 10 of Example 1.

### (Example 2)

The semiconductor substrate 10 subjected to the photoluminescence measurement step S30 in Example 1 was etched at 1600 degrees for 10 minutes under a SiC-C equilibrium vapor pressure environment to prepare a semiconductor substrate 10 from which a subsurface damaged layer 11 is removed and a macro-step bunching MSB is present on a surface (refer to macro-step bunching formation step S40 and Figs. 3 and 5). Thereafter, photoluminescence measurement was performed under a condition similar to that in the comparative example and Example 1 to acquire a captured image of Example 2 (photoluminescence measurement step S30). Note that, the presence or absence of the macro-step bunching MSB was confirmed by SEM and AFM. A step 13 having a height exceeding 1.0 nm (that is, macro-step bunching MSB) was formed on the surface of the semiconductor substrate 10 of Example 2.

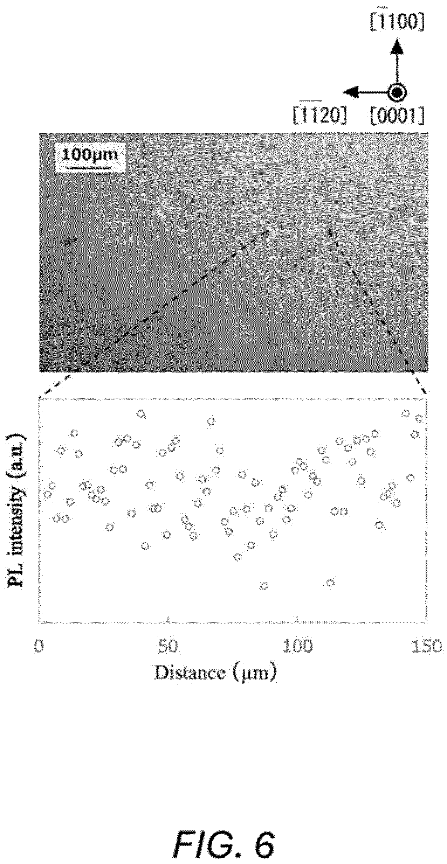

Fig. 6 illustrates the captured image and an intensity profile obtained at the photoluminescence measurement step S30 of the comparative example.

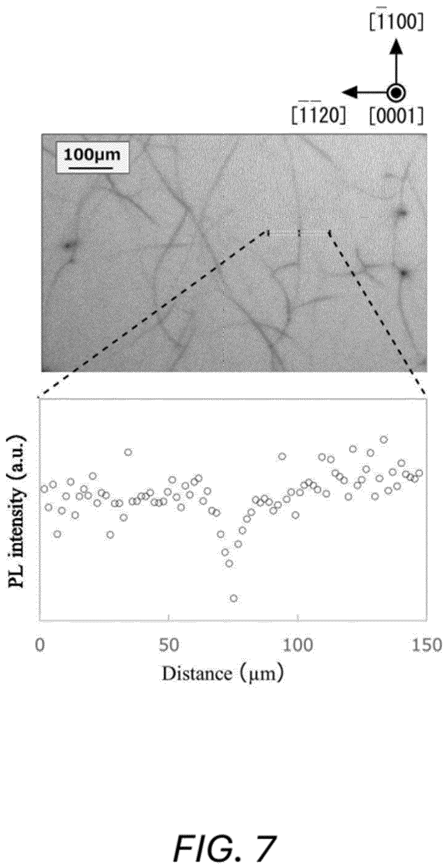

Fig. 7 illustrates the captured image and an intensity profile obtained at the photoluminescence measurement step S30 of Example 1.

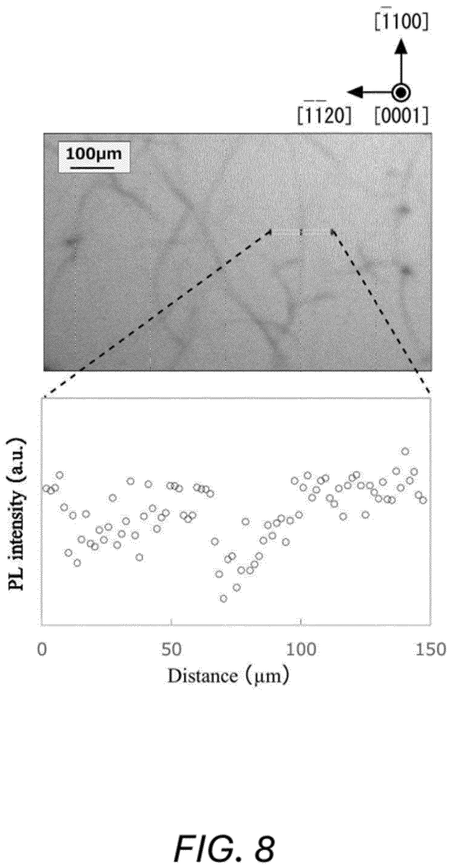

Fig. 8 illustrates the captured image and an intensity profile obtained at the photoluminescence measurement step S30 of Example 2.

Note that, the captured image and intensity profile in Figs. 6, 7, and 8 were obtained by observing the same point. A black linear portion of the captured image is basal plane dislocation, and a black dotted portion is threading dislocation. In the intensity profile, PL intensity information (PL intensity) and position information (distance) are extracted across the same basal plane dislocation.

From the captured image and intensity profile (Fig. 6) of the comparative example, it is found that, in the semiconductor substrate 10 in which the subsurface damaged layer 11 remains, variation in background light emission intensity is large, and it is difficult to obtain a contrast between the light emission intensity in a portion in which crystal defects are observed and the background light emission intensity.

From the captured image and intensity profile (Fig. 7) of Example 1, it is found that, in the semiconductor substrate 10 from which the subsurface damaged layer 11 and the macro-step bunching MSB are removed, variation in background light emission intensity is suppressed, and a contrast between the light emission intensity in a portion in which crystal defects are observed and the background light emission intensity is clearly obtained.

From the captured image and intensity profile (Fig. 8) of Example 2, it is found that, in the semiconductor substrate 10 in which the macro-step bunching MSB is formed, variation in background light emission intensity is suppressed, and the contrast between the light emission intensity in the portion in which crystal defects are observed and the background light emission intensity is obtained as compared with the comparative example.

That is, when the comparative example, Example 1, and Example 2 are compared, it can be grasped that the variation in background light emission intensity is suppressed in Example 1 in which the subsurface damaged layer 11 and the macro-step bunching MSB are removed (refer to Fig. 7).

From the above, it is found that, by removing the subsurface damaged layer 11 of the semiconductor substrate 10, the variation in background light emission intensity in the photoluminescence measurement can be suppressed. It is suggested that, by reducing the subsurface damaged layer 11 of the semiconductor substrate 10, the variation in background light emission intensity in the photoluminescence measurement can be suppressed.

Furthermore, comparing the comparative example with Example 2, it can be grasped that the variation in background light emission intensity is suppressed in Comparative Example 2 from which the subsurface damaged layer 11 is removed (refer to Fig. 8).

From the above, it is found that, by removing the macro-step bunching MSB of the semiconductor substrate 10, the variation in background light emission intensity in the photoluminescence measurement can be suppressed. It is suggested that, by reducing the macro-step bunching MSB of the semiconductor substrate 10, the variation in background light emission intensity in the photoluminescence measurement can be suppressed.

The present invention is the method for evaluating the semiconductor substrate including the photoluminescence measurement step S30 before and after the subsurface damaged layer removal step S10 and/or the macro-step bunching removal step S20.

For example, Example 1 includes a first photoluminescence measurement step S31 of acquiring distribution information of crystal defects of a semiconductor substrate by photoluminescence measurement, a subsurface damaged layer removal step S10 of removing at least a part of the subsurface damaged layer 11 present in the semiconductor substrate 10, a macro-step bunching removal step S20 of removing at least a part of the macro-step bunching MSB present in the semiconductor substrate 10, and a second photoluminescence measurement step S32 of acquiring distribution information of crystal defects of the semiconductor substrate by photoluminescence measurement.

In this manner, by including the photoluminescence measurement step S30 before and after the subsurface damaged layer removal step S10 and/or the macro-step bunching removal step S20, crystal defects of the semiconductor substrate 10 can be appropriately evaluated.

Specifically, at the first photoluminescence measurement step S31, in a case where it is difficult to evaluate crystal defects due to the variation in background light emission intensity, it is possible to evaluate crystal defects present in a bulk layer 12 of the semiconductor substrate 10 by performing the second photoluminescence measurement step S32 after performing the subsurface damaged layer removal step S10 and/or the macro-step bunching removal step S20.

Note that, in the comparative example and the example, an example in which the crystal defects in the bulk layer 12 of the SiC substrate as the semiconductor substrate 10 are observed is illustrated, but the present invention is not limited thereto. For example, the semiconductor substrate 10 may be a SiC epitaxial substrate including an epitaxial layer, or may be another compound semiconductor material.

### Reference Signs List

- 10: Semiconductor substrate
- 11: Subsurface damaged layer
- 12: Bulk layer
- 13: Step
- 14: Terrace
- 20: Main container
- 30: Refractory material container
- S10: Subsurface damaged layer removal step
- S20: Macro-step bunching removal step
- S30: Photoluminescence measurement step
- S40: Macro-step bunching formation step
- MSB: Macro-step bunching

## Claims

1. A method for suppressing variation in background light emission intensity in photoluminescence measurement, the method comprising:
a subsurface damaged layer removal step of removing at least a part of a subsurface damaged layer present in a semiconductor substrate; and
a photoluminescence measurement step of acquiring distribution information of crystal defects of the semiconductor substrate by photoluminescence measurement.

2. A method for suppressing variation in background light emission intensity in photoluminescence measurement, the method comprising:
a macro-step bunching removal step of removing at least a part of a macro-step bunching present in a semiconductor substrate; and
a photoluminescence measurement step of acquiring distribution information of crystal defects of the semiconductor substrate by photoluminescence measurement.

3. A method for suppressing variation in background light emission intensity in photoluminescence measurement, the method comprising:
a subsurface damaged layer removal step of removing at least a part of a subsurface damaged layer present in a semiconductor substrate;
a macro-step bunching removal step of removing at least a part of a macro-step bunching present in the semiconductor substrate; and
a photoluminescence measurement step of acquiring distribution information of crystal defects of the semiconductor substrate by photoluminescence measurement.

4. The method for suppressing variation in background light emission intensity in photoluminescence measurement according to claim 1 or 3, wherein the subsurface damaged layer removal step is a step of removing the subsurface damaged layer by a thermal etching method.

5. The method for suppressing variation in background light emission intensity in photoluminescence measurement according to claim 1 or 3, wherein the subsurface damaged layer removal step is a step of removing at least a part of the subsurface damaged layer by wet etching and/or chemical mechanical polishing.

6. The method for suppressing variation in background light emission intensity in photoluminescence measurement according to claim 2 or 3, wherein the macro-step bunching removal step is a step of removing the macro-step bunching by a thermal etching method.

7. The method for suppressing variation in background light emission intensity in photoluminescence measurement according to claim 2 or 3, wherein the macro-step bunching removal step is a step of heating the semiconductor substrate under a SiC-Si equilibrium vapor pressure environment.

8. The method for suppressing variation in background light emission intensity in photoluminescence measurement according to claim 2 or 3, wherein the macro-step bunching removal step is a step of forming a step having a height of one unit cell or less on a surface of the semiconductor substrate.

9. The method for suppressing variation in background light emission intensity in photoluminescence measurement according to any one of claims 1 to 3, wherein the semiconductor substrate is a compound semiconductor.

10. A method for evaluating a semiconductor substrate, the method comprising: performing photoluminescence measurement on a semiconductor substrate from which at least a part of a subsurface damaged layer is removed.

11. A method for evaluating a semiconductor substrate, the method comprising: performing photoluminescence measurement on a semiconductor substrate from which at least a part of a macro-step bunching is removed.

12. A method for evaluating a semiconductor substrate, the method comprising: performing photoluminescence measurement on a semiconductor substrate from which a subsurface damaged layer and a macro-step bunching are removed.

13. The method for evaluating a semiconductor substrate according to any one of claims 10 to 12, wherein the semiconductor substrate includes a step having a height of one unit cell or less.

14. The method for evaluating a semiconductor substrate according to any one of claims 10 to 12, wherein the semiconductor substrate is a compound semiconductor.
